# EUROPEAN PATENT APPLICATION

(11) **EP 3 657 554 A1**
(43) Date of publication of application: **27.05.2020**
(21) Application number: 17918475.9
(22) Date of filing: 07.09.2017
(51) Int. Cl.: H01L 31/06, H01L 31/0224, H01L 31/0368, H01L 31/0376, H01L 31/032, H01L 31/0236

(54) **PEROVSKITE SOLAR BATTERY AND TANDEM SOLAR BATTERY INCLUDING SAME**

(30) Priority: 21.07.2017 KR 20170092641
(71) Applicant: LG Electronics Inc., Seoul 07336 (KR)
(72) Inventor: AHN, Seh-Won, Seoul 06772 (KR); KIM, Seongtak, Seoul 06772 (KR); LEE, Yu Jin, Seoul 06772 (KR); CHUNG, Jin-Won, Seoul 06772 (KR)
(74) Representative: Katérle, Axel
(86) International application number: PCT/KR2017/009823
(87) International publication number: WO 2019/017522

(57) **Abstract**

The present invention relates to a perovskite solar battery and a tandem solar battery including the same and, more particularly, to a perovskite solar battery, which can ensure reliability and large area uniformity, and a tandem solar battery. According to the present invention, provided are the perovskite solar battery and the tandem solar battery including the same, the perovskite solar battery facilitating reliability and a band gap control by respectively applying a p-type Si thin film layer and an n-type Si thin film layer to a hole transport layer and an electron transport layer, and thus a lifespan and light conversion efficiency can increase.

## Description

### [Technical Field]

The present disclosure relates to a perovskite solar cell and a tandem solar cell including the same, and more particularly, to the perovskite solar cell having improved reliability and uniformity and the tandem solar cell in which the perovskite solar cell is uniformly stacked on a silicon solar cell and are bonded.

### [Background Art]

Crystalline silicon (c-Si) solar cells are representative single-junction solar cells and are currently and widely used as commercial solar cells.

However, various types of new solar cells are being developed due to low photoelectric conversion efficiency of crystalline silicon solar cells.

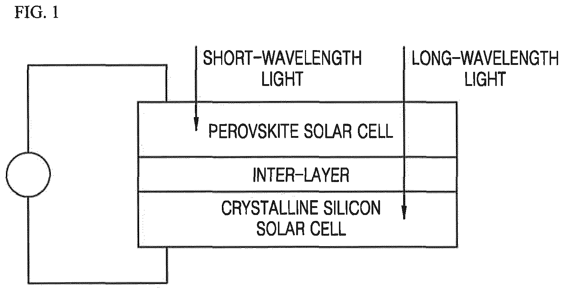

Among them, the perovskite solar cell has advantages in that the perovskite solar cell may manufacture a photo-activation layer through a relatively simple solution process and may have higher photoelectric conversion efficiency than that of the silicon solar cell. As a result, perovskite solar cells and tandem solar cells (see FIG. 1) that connects silicon solar cells and perovskite solar cells have attracted much attention despite of a short development history.

The perovskite solar cell includes an electron transport layer and a hole transport layer that help transfer of charges such as electrons or holes as a light absorption layer.

In related art, polymer materials such as poly-3,4-ethylenedioxythiophene-polystyrenesulfonate (PEDOT-PSS), poly-[bis(4-phenyl)(2,4,6-trimethylphenyl)amine] (PTAA), Spiro-MeOTAD or polyaniline-camphorsulfonic acid (PANI-CSA) are used as a material of the hole transport layer.

The polymer material has a problem that polymer material is difficult to provide reliability due to high temperature deterioration, which is a unique property of the polymer, and furthermore, there is a disadvantage that the polymer material may not easily provide uniformity in a large area.

Titanium oxide (TiO₂), which has been used as a material of an electron transport layer, also has a problem in that titanium oxide decomposes a perovskite layer through absorption of light due to photocatalytic action, which is a unique property of the material itself.

The related art document with respect to the present disclosure is Korean Patent No. 10-1540364 (registered on July 23, 2015). The related art document discloses a perovskite solar cell using a new material based on Zn₂SnO₄ (ZSO), which replaces titanium dioxide in related art.

### [Disclosure]

### [Technical Problem]

The present disclosure provides a perovskite solar cell and a tandem solar cell including the same. The perovskite solar cell with high efficiency/in a large area and the tandem solar cell including the same are provided using a thin film made of doped silicon or doped silicon-based compound and have excellent reliability and easily control a band gap.

### [Technical Solution]

In order to solve the above technical problems, according to a first aspect of the present disclosure, there may be provided a solar cell including a hole transport layer which is a p-type hole transport layer and having a composition containing silicon (Si); a perovskite layer disposed on the hole transport layer; an electron transport layer disposed on the perovskite layer.

Preferably, there may be provided the solar cell characterized in that the hole transport layer is disposed on a transparent electrode on a transparent substrate and a metal electrode layer is disposed above the electron transport layer.

There may also be provided the solar cell characterized in that the solar cell further includes a silicon solar cell including a crystalline silicon substrate and the hole transport layer is disposed above the silicon solar cell; and the solar cell including a front electrode disposed above the electron transport layer.

In particular, there may be provided a solar cell including an inter-layer between the silicon solar cell and the hole transport layer.

Preferably, there may be provided a solar cell characterized in including a buffer layer between the hole transport layer and the perovskite layer.

In particular, there may be provided the solar cell characterized in that the buffer layer is made of one or two or more of NiOₓ, MoOₓ, CuSCN, and Cul.

Preferably, there may be provided the solar cell characterized in including a transparent electrode between the electron transport layer and the electron.

Preferably, there may be provided the solar cell characterized in that the silicon solar cell includes a first intrinsic amorphous silicon layer (i-a-Si:H) disposed on a first surface of the crystalline silicon substrate and a second intrinsic amorphous silicon layer (i-a-Si:H) disposed on a second surface of the crystalline silicon substrate; a first semiconductor-type amorphous silicon layer disposed on the first intrinsic amorphous silicon layer; and a second semiconductor-type amorphous silicon layer disposed on a rear surface of the second intrinsic amorphous silicon layer.

Preferably, there may be provided the solar cell characterized in that a layer which is a p-type and having a composition containing the silicon (Si) is made of one or two or more of amorphous silicon (p-a-Si), amorphous silicon oxide (p-a-SiO), amorphous silicon nitride (p-a-SiN), amorphous silicon carbide (p-a-SiC), amorphous silicon acid nitride (p-a-SiON), amorphous silicon carbonitride (p-a-SiCN), amorphous silicon germanium (p-a-SiGe), microcrystalline silicon (p-µc-Si), microcrystalline silicon oxide (p-µc-SiO), microcrystalline silicon carbide (p-µc-SiC), microcrystalline silicon nitride (p-µc-SiN), microcrystalline silicon germanium (p-µc-SiGe).

Preferably, there may be provided the solar cell characterized in that the perovskite layer includes a material having a formula of FA₁₋ₓCsₓPbBr_{y}I_{3-y} (where 0 ≤ x ≤ 1 and 0 ≤ y ≤ 3).

Preferably, there may be provided the solar cell characterized in that the electron transport layer is made of one or two or more of ZnO, SnO₂, CdS, PCBM, or C₆₀.

According to yet another aspect of the present disclosure, there may be provided the solar cell including an electron transport layer which is an n-type electron transport layer and having a composition containing silicon (Si); the perovskite layer disposed on the electron transport layer; and the hole transport layer disposed on the perovskite layer.

Preferably, there may be provided the solar cell characterized in that the electron transport layer is disposed on a transparent electrode disposed on a transparent substrate and the metal electrode layer is disposed above the hole transport layer.

There may also be provided the solar cell characterized in that the solar cell further includes a silicon solar cell including a crystalline silicon substrate and the hole transport layer is disposed above the silicon solar cell; the solar cell including a front electrode disposed above the hole transport layer.

In particular, there may be provided the solar cell characterized in including an inter-layer between the silicon solar cell and the electron transport layer.

Preferably, there may be provided the solar cell characterized in including a buffer layer between the electron transport layer and the perovskite layer.

In particular, there may be provided the solar cell in which the buffer layer is made of one or two or more of TiOₓ, ZnO, SnO₂, CdS, PCBM, and C₆₀.

Preferably, there may be provided the solar cell characterized in including a transparent electrode between the hole transport layer and the electrode.

Preferably, there may be provided the solar cell characterized in that the silicon solar cell includes a first intrinsic amorphous silicon layer (i-a-Si:H) disposed on the first surface of the crystalline silicon substrate and a second intrinsic amorphous silicon layer (i-a-Si-H) disposed on the second surface of the crystalline silicon substrate; a first semiconductor-type amorphous silicon layer disposed on the first intrinsic amorphous silicon layer; and a second semiconductor-type amorphous silicon layer disposed on the rear surface of the second intrinsic amorphous silicon layer.

Preferably, there may be provided the solar cell characterized in that the layer which is the n-type layer and having a composition containing silicon (Si) is made of one or two or more of amorphous silicon (n-a-Si), amorphous silicon oxide (n-a-SiO), amorphous silicon nitride (n-a-SiN), amorphous silicon carbide (n-a-SiC), amorphous silicon oxynitride (n-a-SiON), amorphous silicon carbonitride (n-a-SiCN), amorphous silicon germanium (n-a-SiGe), microcrystalline silicon (n-µc-Si), microcrystalline silicon oxide (n-µc-SiO), microcrystalline silicon carbide (η-µc-SiC), microcrystalline silicon nitride (n-µc-SiN), or microcrystalline silicon germanium (n-µc-SiGe).

Preferably, there may be provided the solar cell characterized in that the perovskite layer includes material having the formula of FA₁₋ₓCsₓPbBr_{y}I_{3-y} (where 0 ≤ x ≤ 1 and 0 ≤ y ≤ 3).

Preferably, there may be provided the solar cell characterized in that the hole transport layer is made of one or two or more of Spiro-OMeTAD, PTAA, NiO, MoOₓ, Cul, and CuSCN.

### [Advantageous Effects]

According to the present disclosure, a thin film made of doped silicon or a doped silicon-based compound, which has been proven to be reliable in other silicon solar cell fields, may be used for a hole transport layer or an electron transport layer of a perovskite solar cell and a tandem solar cell including the same.

Accordingly, there is an effect of providing a commercial, scale-up, and large-area perovskite solar cell and a tandem solar cell including the same.

Meanwhile, a thin film made of doped silicon or a doped silicon-based compound rather than an organic material in related art may be used as the hole transport layer of the perovskite solar cell, thereby greatly improving the reliability at high temperatures.

The perovskite absorption layer may be decomposed due to a photocatalytic effect of TiO₂. By using a thin film made of a doped silicon or a doped silicon compound rather than TiO₂ in related art as the electron transport layer of the perovskite solar cell, the decomposition of the absorption layer due to the photocatalytic effect of TiO₂ may be prevented to greatly improve photoelectric conversion efficiency and degradation in reliability.

According to the present disclosure, the perovskite solar cell and the tandem solar cell including the same may also design a band gap of the material of the hole transport layer or the electron transport layer by adjusting a composition and/or a doped concentration of a thin film made of doped silicon or doped silicon-based compound.

The band gap may be variously controlled through band-gap engineering, and thus, it has an effect of improving the photoelectric conversion efficiency of the perovskite solar cell and the tandem solar cell including the same.

According to the present disclosure, the band gap of the perovskite layer may also be freely designed (about equal to or greater than 1.7 eV) by adding Br as well as using formamidinium (FA)-based composition of the perovskite absorption layer. Thermal stability of the absorption layer may be maintained up to 120°C.

The perovskite solar cell and the tandem solar cell including the same having improved photoelectric conversion efficiency and reliability of the solar cell may be provided through the above configuration.

### [Description of Drawings]

FIG. 1 is a schematic diagram showing a general tandem solar cell.
FIGS. 2(a) and 2(b) are cross-sectional views showing perovskite solar cells according to a first embodiment of the present disclosure.
FIGS. 3(a) and 3(b) are cross-sectional views showing tandem solar cells according to a second embodiment of the present disclosure.
FIG. 4 shows results of measurement through Raman spectroscopy with respect to amorphous silicon (a-Si), microcrystalline silicon (µc-Si), and polycrystalline silicon (poly-Si).
FIG. 5 is a schematic diagram showing a perovskite solar cell and a band gap corresponding thereto according to a first embodiment of the present disclosure.
FIGS. 6(a) and 6(b) are cross-sectional views showing perovskite solar cells according to a third embodiment of the present disclosure.
FIGS. 7(a) and 7(b) are cross-sectional views showing tandem solar cells according to a fourth embodiment of the present disclosure.
FIG. 8 is a schematic diagram showing a perovskite solar cell and a band gap corresponding thereto according to a third embodiment of the present disclosure.
FIGS. 9 to 16 are process cross-sectional views showing a method for manufacturing a tandem solar cell according to a second exemplary embodiment of the present disclosure.

### [Best Mode]

A tandem solar cell and a method of manufacturing the same according to a preferred embodiment of the present disclosure are described below in detail with reference to the accompanying drawings.

The present disclosure is not limited to the embodiments disclosed below, but may be implemented in various manners, and these embodiments are provided so that this disclosure will be thorough and complete, and will fully convey the scope of the invention to those skilled in the art.

### Embodiments 1 and 2

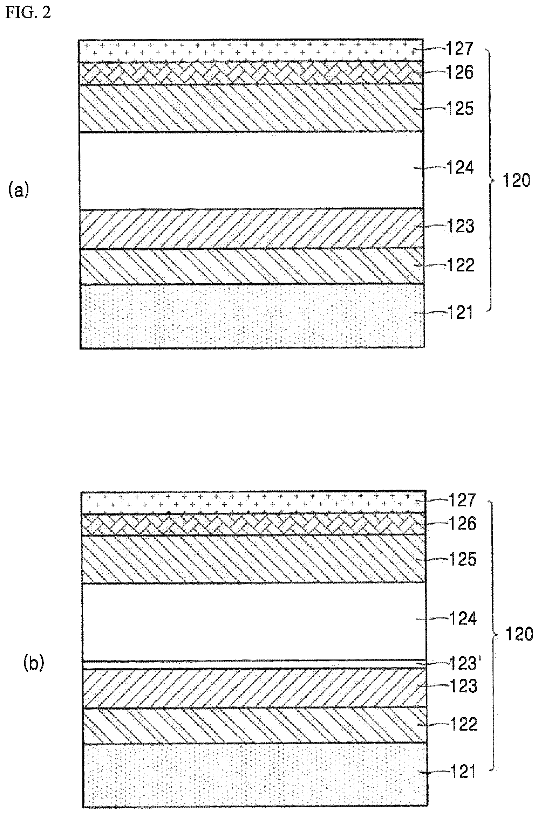

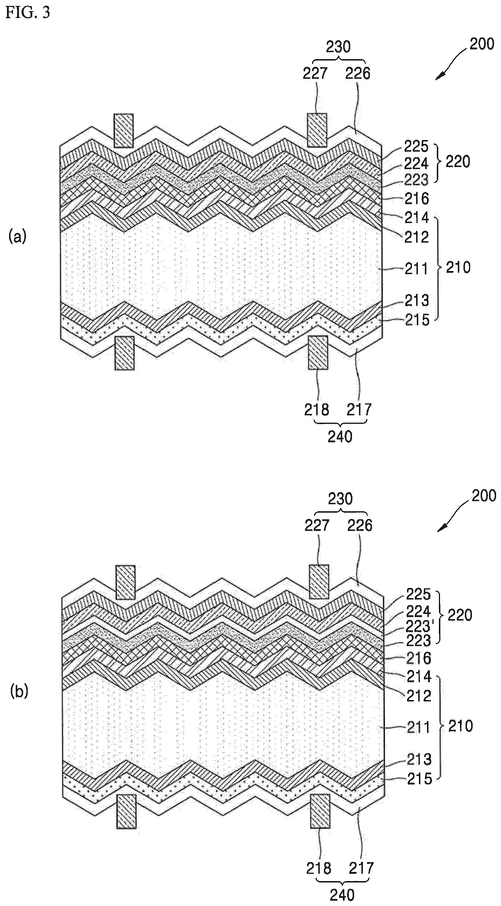

FIG. 2 is a cross-sectional view showing a perovskite solar cell according to a first embodiment of the present disclosure in detail. FIG. 3 is a cross-sectional view showing a tandem solar cell according to a second embodiment of the present disclosure in detail.

First, according to a first embodiment and a second embodiment of the present disclosure, a solar cell includes a hole transport layer which is a p-type hole transport layer and having a composition containing silicon (Si); a perovskite layer disposed on the hole transport layer; and an electron transport layer disposed on the perovskite layer.

Referring to FIG. 2, according to the first embodiment of the present disclosure, the perovskite solar cell 120 includes a glass substrate 121; a transparent electrode 122 disposed on the glass substrate 121; a hole transport layer 123 disposed on the transparent electrode 122 and which is a p-type hole transport layer 123 and having a composition containing silicon (Si); a perovskite layer 124 disposed on the hole transport layer 123; an electron transport layer 125 disposed on the perovskite layer 124; and an electrode 127 disposed above the electron transport layer 125.

In this case, a transparent electrode 126 may be inserted between the electron transport layer 125 and the electrode 127 as necessary to increase reflectance, but the transparent electrode 126 is not necessarily required. When the transparent electrode 126 is additionally included, wetting property between the electrode 127 and the transparent electrode 126 is also improved to thereby obtain an additional effect of improving contact properties between the electrodes.

A buffer layer 123' may be additionally disposed between the hole transport layer 123 and the perovskite layer 124.

The buffer layer 123' may function to minimize defects occurring at an interface due to different components and different crystal structures between the hole transport layer 123 and the perovskite layer 124.

The buffer layer 123' may also improve hole transport properties between the hole transport layer 123 and the perovskite layer 124. More specifically, the buffer layer 123' may block unwanted charge carriers (electrons and holes) to greatly improve selectivity in charge extraction.

Furthermore, even when the hole transport layer 123 may not sufficiently perform the function of hole transport, the buffer layer alone may perform the function of the hole transport layer to some extent.

To this end, according to the present disclosure, the buffer layer 123' is characterized in that the buffer layer 123' is made of one or two or more of NiOₓ, MoOₓ, CuSCN, and CuI.

Further, the buffer layer 123' preferably has a thickness of 20 nm or less. Based on the buffer layer 123' having the thickness exceeding 20 nm, hole transport loss may occur due to an excessively greater thickness. Meanwhile, a lower limit of the thickness thereof may not be required to be specifically defined when the buffer layer 123' is stably formed.

According to the first embodiment of the present disclosure, the perovskite solar cell 120 has a structure in which the hole transport layer 123 is disposed above the glass substrate 121 before the electron transport layer 125. This structure is a so-called inverted structure.

The tandem solar cell 200 in FIG. 3 also has a structure of a 2-terminal tandem solar cell in which a perovskite solar cell 220 including an absorption layer having a relatively greater band gap and a silicon solar cell 210 including an absorption layer having a relatively less band gap are directly tunnel-junctioned through a medium of an inter-layer 216 (hereinafter; also referred to as "junction layer", "tunnel junction layer", and "inter-layer).

Accordingly, light of a short wavelength region of lights incident onto the tandem solar cell 200 is absorbed by the perovskite solar cell 220 disposed at an upper portion thereof to generate charges, and light in a long wavelength region transmitting the perovskite solar cell 220 of lights incident on the tandem solar cell 200 is absorbed by the silicon solar cell 210 disposed at a lower portion thereof to generate charges.

The tandem solar cell 200 having the above-described structure may generate power by absorbing the light in the short wavelength region by the perovskite solar cell 220 disposed at the upper portion thereof. As a result, the perovskite layer having the high band gap absorbs short-wavelength sunlight having the high energy, which has not been absorbed by the silicon solar cell 210 in related art, to thereby reduce thermal loss occurring due to difference between photon energy and a band gap. As a result, a high voltage may be generated by reducing thermal loss of the solar cell to thereby improve the light conversion efficiency of the solar cell.

A threshold wavelength may also be shifted toward the long wavelength by absorbing, by the silicon solar cell 210 disposed at the lower portion thereof, the light in the long wavelength region and generating the power, and consequently, there is an additional advantage that an entire wavelength band absorbed by the solar cell may be widened.

According to the second embodiment of the present disclosure, the tandem solar cell 200 described above includes a crystalline silicon solar cell 210, a hole transport layer 223 disposed above the crystalline silicon solar cell and which is a p-type hole transport layer 223 and having a composition containing silicon (Si); a perovskite layer 224 disposed on the hole transport layer 223; an electron transport layer 225 disposed on the perovskite layer 224; a front transparent electrode 226 disposed on the electron transport layer 225, and a front electrode 227 disposed on the front transparent electrode 226.

A buffer layer 223'may be additionally disposed between the hole transport layer 223 and the perovskite layer 224 as described in the first embodiment.

At this time, an inter-layer 416 may be inserted as necessary between the crystalline silicon solar cell 410 and the hole transport layer 423 for charge transfer. In this case, the inter-layer 216 may be made of transparent conductive oxide, a carbonaceous conductive material, a metallic material in order for the long-wavelength light transmitted through the perovskite solar cell 420 to be incident onto the silicon solar cell 410 disposed at the lower portion thereof without loss of transmission. The doped n-type or p-type material may also be used for the inter-layer 416.

In this case, indium tin oxide (ITO), indium tungsten oxide (IWO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum doped zinc oxide (AZO), fluorine tin oxide (FTO) or ZnO may be used as examples of the transparent conductive oxide.

Graphene or carbon nanotube may be used as the carbonaceous conductive material, and metal (Ag) nano wire and a multi-layered metal thin film including Au/Ag/Cu/Mg/Mo/Ti may be used as metallic material.

Meanwhile, in a single-junction solar cell, it is general to introduce a texture structure on the surface thereof to reduce the reflectance of incident light on the surface thereof and to increase a path of light incident on the solar cell. Therefore, according to the present disclosure, the crystalline silicon solar cell 210 of the tandem solar cell 200 may also form a texture on the surface thereof (on at least a rear surface thereof).

In this case, according to the present disclosure, the crystalline silicon solar cell 410 may include a heterojunction silicon solar cell or a homojunction silicon solar cell.

More specifically, the heterojunction silicon solar cell includes a crystalline silicon substrate 211 having a texture structure on a second surface thereof, a first intrinsic amorphous silicon layer (i-a-Si:H) 212 disposed on a first surface of the crystalline silicon substrate and a second intrinsic amorphous silicon layer (i-a-Si:H) 213 disposed on the second surface of the crystalline silicon substrate; a first semiconductor-type amorphous silicon layer 214 disposed on the first intrinsic amorphous silicon layer 212; and a second semiconductor-type amorphous silicon layer 215 disposed on a rear surface of the second intrinsic amorphous silicon layer 213.

For example, first, a passivation layer made of very thin amorphous intrinsic silicon (i-a-Si:H) is formed on a first surface and a second surface of a p-type crystalline silicon substrate and an n-type amorphous silicon (p-a-Si:H) layer having a high concentration is formed on the first surface thereof as the emitter layer 114, and high-concentration amorphous silicon (p⁺-a-Si:H) layer is formed on the second surface thereof as a back surface field (BSF) layer 115.

The amorphous silicon layer has a greater energy band gap of about 0.6 to 0.7 eV than the crystalline silicon layer having an energy band gap of about 1.1 eV, and there is an advantage that a very thin amorphous silicon layer may be formed during a deposition process. The amorphous silicon layer may have an advantage that light utilization may be increased by minimizing light absorption loss in the short wavelength region, and may have a high open voltage and a BSF effect.

In general, in the case of heterojunction having different band gaps, there is a high possibility of occurring lattice mismatch between materials different from each other. However, when the amorphous silicon layer is used, the lattice mismatch may not occur because the amorphous material has a crystal lattice with no regularity, in contrast to the crystalline material. As a result, when an intrinsic amorphous silicon layer (i-a-Si) is deposited on the crystalline silicon substrate, there is an advantage that recombination with the surface of the silicon substrate is effectively reduced.

According to the present disclosure, a hydrogenated intrinsic amorphous silicon layer (i-a-Si: H) may be preferably used as the intrinsic amorphous silicon layer. Hydrogen may be permeated into the amorphous silicon through hydrogenation reaction to reduce a dangling bond of the amorphous silicon and localized energy in the energy band gap.

However, when the hydrogenated intrinsic amorphous silicon layer (i-a-Si: H) is used, a subsequent process temperature is limited to 250°C or less, more preferably, 200°C or less. When the process temperature is higher than 200°C, hydrogen bond inside the amorphous silicon is destroyed.

Therefore, there is a restriction that firing may be performed at low temperatures during a subsequent process, in particular, a process of forming a grid electrode made of metal. By contrast, there is an additional advantage that thermal damage may be reduced as the subsequent process temperature is low.

Further, according to the present disclosure, the silicon solar cell 210 may include a homojunction crystalline silicon solar cell. Specifically, a semiconductor-type impurity doping layer different from of the semiconductor-type crystalline silicon substrate 211 is used as an emitter layer 214 disposed on the first surface thereof, and an impurity doping layer having the same type of semiconductor as the crystalline silicon substrate 211 is used as the electric field layer 215 disposed on the second surface thereof to implement the homojunction crystalline silicon solar cell 210.

Of course, when the silicon solar cell is the homojunction silicon solar cell, it is not required to include passivation layers 212 and 213 made of amorphous intrinsic silicon.

According to the present disclosure, in the perovskite solar cell and a tandem solar cell including the same, the hole transport layer which is the p-type hole transport layer and having a composition containing silicon (Si) is made of, more specifically, one or two or more of amorphous silicon (p-a-Si), amorphous silicon oxide (p-a-SiO), amorphous silicon nitride (p-a-SiN), amorphous silicon carbide (p-a-SiC), amorphous silicon oxynitride (p-a-SiON), amorphous silicon carbonitride (p-a-SiCN), amorphous silicon germanium (p-a-SiGe), microcrystalline silicon (p-µc-Si), microcrystalline silicon oxide (p-µc-SiO), microcrystalline silicon carbide (p-µc-SiC), microcrystalline silicon nitride (p-µc-SiN), and microcrystalline silicon germanium (p-µc-SiGe).

According to the present disclosure, the hole transport layer may control a band gap and a work function of a p-type layer including an Si alloy or Si through control of the composition and the doping concentration of the Si alloy.

Meanwhile, the amorphous silicon (a-Si), microcrystalline silicon (µC-Si) and polycrystalline silicon (poly-Si) in the present disclosure are all chemically the same component, and thus, these silicon layers are distinguished from one another through a physical method.

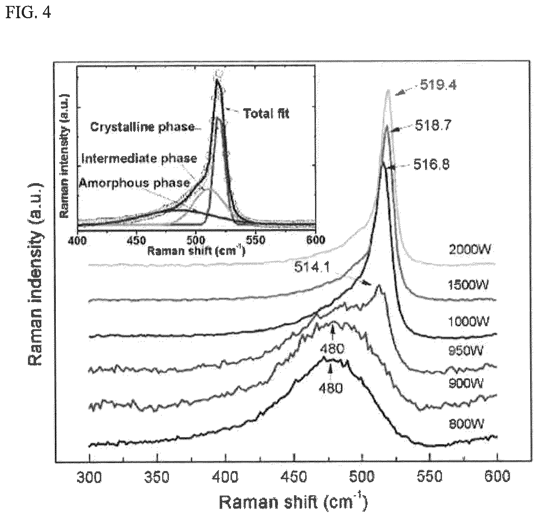

FIG. 4 clearly shows how amorphous silicon (a-Si), microcrystalline silicon (µC-Si), and polycrystalline silicon (poly-Si) are distinguished from one another through RAMAN spectroscopic measurements.

According to the present disclosure, Raman spectrum was measured using a Jasco 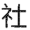 NRS-3200 micro-Raman system. More specifically, target Si thin films were measured using a Nd:YAG laser (532 nm) as an excitation source under conditions ranging from 10 to 20 mW of power.

First, in the case of amorphous silicon, a broad peak is observed at 480 cm⁻² as a result of the Raman spectroscopic measurement. By contrast, in the case of microcrystalline silicon, which is generally known to have a grain size of about several tens of nm, it is measured that peaks of 480 cm⁻² (amorphous phase) and 510 cm⁻² (defective silicon crystal phase) and 520 cm⁻² (silicon crystal phase) are mixed. Finally, the crystalline silicon has a grain size of 1 to 1,000 µm and only a peak of 520 cm⁻² (silicon crystal phase) is observed. Therefore, the amorphous silicon (a-Si), the microcrystalline silicon (µC-Si), and the polycrystalline silicon (poly-Si) may be distinguished from one another through the Raman spectroscopic measurement.

Meanwhile, according to the present disclosure, the doped Si thin film layer, which is a hole transport layer, preferably has electrical conductivity of at least 10⁻⁵S/cm or more.

Based on the electrical conductivity thereof being less than 10⁻⁵S/cm, a charge mobility is basically too low to perform a basic function as a hole transport layer or an electron transport layer.

Further, the hole transport layer preferably has a thickness of 10 nm to 100 nm.

Based on the hole transport layer having the thickness less than 10 nm, there is a high possibility that tunneling occurs and it may not perform the function for the hole transport layer. Meanwhile, based on the hole transport layer having the thickness greater than 100 nm, there may be a problem that the light transmittance is lowered due to excessive thickness thereof.

According to the present disclosure, the hole transport layer which is the p-type hole transport layer and having a composition containing Si is coupled to a perovskite absorption layer made of formamidinium (FA) to provide synergistic effect in terms of band gap design.

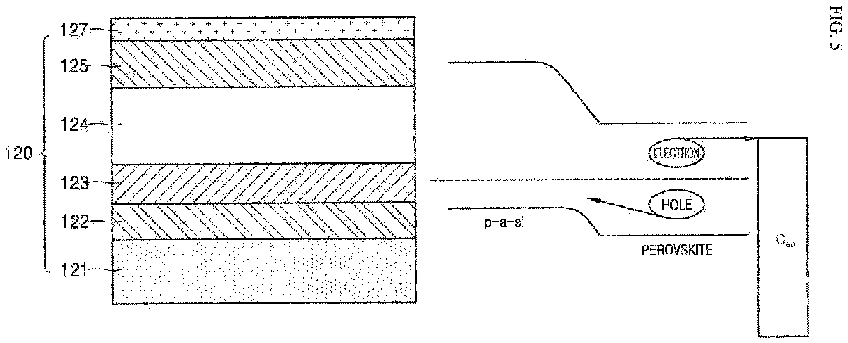

FIG. 5 shows a perovskite solar cell and a band gap corresponding thereto according to a first embodiment of the present disclosure. Methylamminium (MA) (PbI₃), which has been used as a representative perovskite absorption layer, is known to have a band gap of about (1.55 to 1.6) eV. Meanwhile, according to the present disclosure, the FA-based perovskite absorption layer is known to have the band gap less than a band gap of a MA-based perovskite absorption layer. For example, FAPbI₃ has a band gap of about 1.45 eV.

According to the present disclosure, it may be seen that, from FIG. 5, the hole generated by the perovskite absorption layer may be easily moved to the hole transport layer which is the p-type hole transport layer and having Si due to the lesser band gap in the case of the hole transport layer which is the p-type hole transport layer and including Si thin film layer being coupled to the FA-based perovskite absorption layer, compared to the case in which the hole transport layer including the p-type hole transport layer and including Si thin film layer being coupled to the MA-based perovskite absorption layer.

Therefore, in the present disclosure, a material containing formamidinium (FA) of the perovskite absorption layer is preferable.

More preferably, FA₁₋ₓCsₓPbBr_{y}I_{3-y} (where 0 ≤ x ≤ 1 and 0 ≤ y ≤ 3) is preferable.

The FA-based perovskite absorption layer has excellent high temperature stability compared to high temperature stability of the MA-based perovskite absorption layer, and may suppress production of unwanted delta (6) phase FA-based compounds due to addition of Cs.

The band gap of the FA-based perovskite absoption layer may also be increased to a degree similar to the band gap of the MA-based perovskite absoption layer due to addition of Br. Based on the band gap energy including a high range, the high band gap perovskite layer absorbs light of short wavelength compared to the silicon solar cell in related art, thereby reducing the thermal loss caused by the difference between the photon energy and the band gap to generate a high voltage. As a result, the efficiency of the solar cell is eventually improved.

Meanwhile, in the first and second embodiments of the present disclosure, the electron transport layer preferably selects materials other than representative TiO₂ in related art. The perovskite absorption layer having poor material stability may be decomposed due to the photocatalytic action unique to TiO₂.

Thus, according to the present disclosure, the electron transport layer is preferably made of one or two or more materials of ZnO, SnO₂, CdS, PCBM, or C₆₀, and more preferably, C₆₀ (buckminsterfullerene).

In view of the band gap in FIG. 5, C₆₀ has significantly excellent electron conductivity than other candidate materials. Therefore, when C₆₀ is used as the material of the electron transport layer in the first and second embodiments of the present disclosure, C₆₀ may have an excellent effect in terms of electron transport compared to other materials of the electron transport layer.

### Embodiments 3 and 4

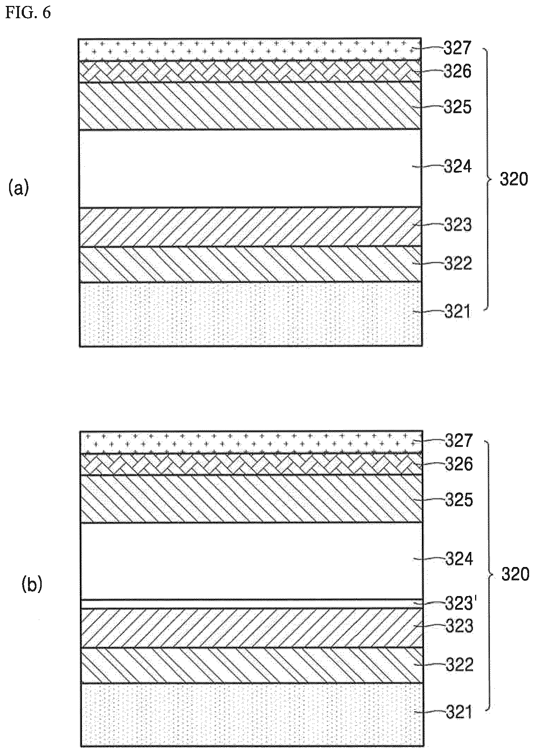

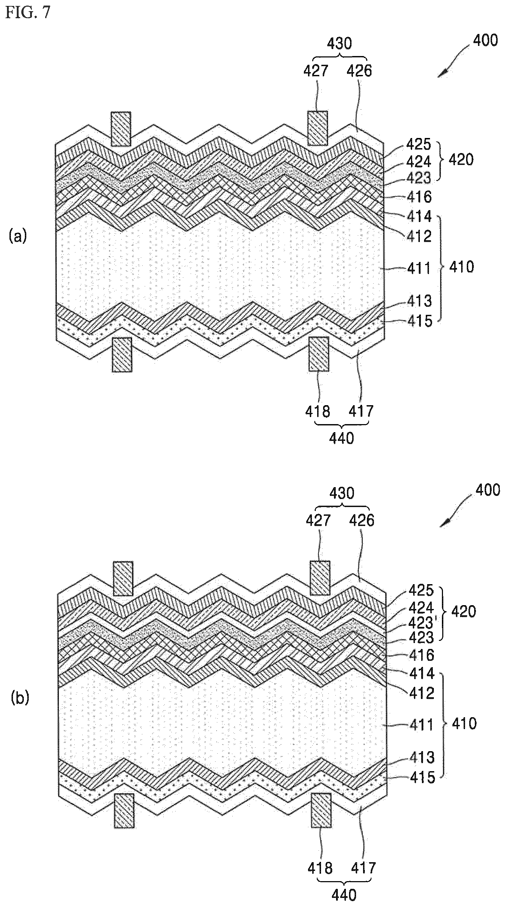

FIG. 6 is a cross-sectional view showing a perovskite solar cell in detail according to a third embodiment of the present disclosure. FIG. 7 is a cross-sectional view showing a tandem solar cell in detail according to a fourth embodiment of the present disclosure.

First, according to the third embodiment and the fourth embodiment of the present disclosure, a solar cell includes an electron transport layer which is an n-type electron transport layer and having a composition containing silicon (Si); a perovskite layer disposed on the electron transport layer; and a hole transport layer disposed on the perovskite layer.

Referring to FIG. 6, according to the third embodiment of the present disclosure, the perovskite solar cell 320 includes a glass substrate 321; a transparent electrode 322 disposed on the glass substrate 321; an electron transport layer 323 disposed on the transparent electrode 322 and which is an n-type electron transport layer 323 and having a composition containing silicon (Si); a perovskite layer 324 disposed on the electron transport layer 323; a hole transport layer 325 disposed on the perovskite layer 324; and an electrode 327 disposed above the hole transport layer 325.

At this time, as being inserted between the electron transport layer 125 and the electrode 127 in the first embodiment, the transparent electrode 326 may be inserted between the hole transport layer 325 and the electrode 327 as necessary to increase reflectance, but the transparent electrode 326 is not necessarily required. Further, in the third embodiment, when the transparent electrode 326 is additionally included, a wetting property between the electrode 327 and the transparent electrode 326 is improved to thereby obtain an additional effect that a contact property between the electrodes may be improved.

Further, a buffer layer 323' may be additionally disposed between the electron transport layer 323 and the perovskite layer 324 as described in the first and second embodiments.

The buffer layer 323' may perform a function for improving electron transfer properties between the electron transport layer 323 and the perovskite layer 324 and for minimizing defects at an interface occurring due to different components and different crystal structures between the electron transport layer 323 and the perovskite layer 324. Furthermore, even when the electron transport layer 323 may not sufficiently perform the function of electron transport, the buffer layer 323' alone may partially perform the function of the electron transport layer.

To this end, according to the present disclosure, the buffer layer 323'is characterized in that the buffer layer 323'is made of one or two or more of TiOₓ, ZnO, SnO₂, CdS, PCBM, and C₆₀.

Further, the buffer layer 323' preferably has a thickness of 20 nm or less. Based on the buffer layer 323' having the thickness exceeding 20 nm, the hole transfer loss may occur due to the excessively greater thickness thereof. Meanwhile, a lower limit of the thickness thereof may not be specifically defined when the buffer layer 323' is stably formed.

According to the third embodiment of the present disclosure, the perovskite solar cell 320 has a normal structure in which the electron transport layer 323 is formed before the electron transport layer 325 above the glass substrate 321.

Further, according to the fourth embodiment of the present disclosure, the tandem solar cell 400 shown in FIG. 7 has a structure of a two-terminal tandem solar cell in which the perovskite solar cell 420 including an absorption layer having a relatively greater band gap and a silicon solar cell 410 including an absorption layer having a relatively less band gap are bonded.

Accordingly, light in a short wavelength region of lights incident on the tandem solar cell 400 is absorbed by the perovskite solar cell 420 disposed at an upper portion thereof to generate charge, and the light of a long wavelength region that has transmitted the perovskite solar cell 420 is absorbed by a silicon solar cell 410 disposed at a lower portion thereof to generate charge.

The tandem solar cell 200 having the above-described structure may generate power by absorbing, by the perovskite solar cell 220 disposed at the upper portion thereof, the light in the short wavelength region. As a result, the perovskite layer having the high band gap absorbs short-wavelength sunlight having the high energy that has not been absorbed by the silicon solar cell 210 in related art to thereby reduce thermal loss caused by the difference between the photon energy and the band gap. As a result, a high voltage may be generated by reducing the thermal loss of the solar cell, thereby increasing the light conversion efficiency of the solar cell.

Further, threshold wavelength may be shifted toward the long wavelength by absorbing, by the silicon solar cell 210 disposed at the lower portion thereof, the light in the long wavelength region, and generating the power in the long wavelength region, and as a result, an additional effect may be obtained in which an entire wavelength band absorbed by the solar cell may be widened.

According to the fourth embodiment of the present disclosure, the tandem solar cell 400 described above includes a crystalline silicon solar cell 410, an electron transport layer 423 disposed above the crystalline silicon solar cell and including an n-type electron transport layer 423 and including an Si thin film layer; a perovskite layer 424 disposed on the electron transport layer 423; a hole transport layer 425 disposed on the perovskite layer 424; and a front transparent electrode 426 disposed on the hole transport layer 425, and a front electrode 427 disposed on the front transparent electrode.

Further, a buffer layer 423' may be additionally disposed between the electron transport layer 423 and the perovskite layer 424, in the same manner as the third embodiment.

At this time, similar to the second embodiment, an inter-layer 416 may be inserted between the crystalline silicon solar cell 410 and the hole transport layer 423 as necessary for charge transfer. In this case, the inter-layer may be made of transparent conductive oxide, a carbonaceous conductive material, a metallic material or a conductive polymer in order for the long-wavelength light transmitted through the perovskite solar cell 420 to be incident to the silicon solar cell 410 disposed at the lower portion thereof without transmission loss. A doped n-type material or p-type material may also be used for the inter-layer 416.

In this case, indium tin oxide (ITO), indium tungsten oxide (IWO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum doped zinc oxide (AZO), fluorine tin oxide (FTO) or ZnO may be used as examples of the transparent conductive oxide.

Graphene or carbon nanotube may be used as the carbonaceous conductive material and metal (Ag) nanowires and a multi-layered metal thin film including Au/Ag/Cu/Mg/Mo/Ti may be used as the metallic material.

Meanwhile, in a single-junction solar cell, a texture structure is usually introduced to a surface thereof (at least on a rear surface thereof) to reduce the reflectance of incident light on the surface and to increase a path of light incident on the solar cell. Therefore, according to the fourth embodiment of the present disclosure, the crystalline silicon solar cell 410 of the tandem solar cell may also form a texture on the surface thereof.

In this case, according to the present disclosure, the crystalline silicon solar cell 410 may include a heterojunction silicon solar cell or homojunction silicon solar cell, as described with respect to the crystalline silicon solar cell 210 of the second embodiment.

More specifically, in the case of a heterojunction silicon solar cell, the crystalline silicon solar cell includes a crystalline silicon substrate 411 having a texture structure on a second surface thereof, a first surface intrinsic amorphous silicon layer (i-a-Si:H) 412 disposed on a first surface of the crystalline silicon substrate and a second surface intrinsic amorphous silicon layer (i-a-Si:H) 413 disposed on the second surface of the crystalline silicon substreate; a first semiconductor-type amorphous silicon layer 414 disposed on the first surface intrinsic amorphous silicon layer on the first surface thereof; and a second semiconductor-type amorphous silicon layer 415 disposed on a rear surface of the second intsindic amorphous silicon layer.

For example, a passivation layer made of very thin amorphous intrinsic silicon (i-a-Si: H) is formed on the first surface and the second surface of an n-type crystalline silicon substrate and a p-type-high-concentration-amorphous silicon (p-a-Si:H) layer is formed on the front surface thereof as an emitter layer 414 and the high-concentration-amorphous silicon (n⁺-a-Si:H) layer is formed on the rear surface thereof as a back surface field (hereinafter; referred to as "BSF") layer 415.

Further, the silicon solar cell 410 of the present disclosure, like the silicon solar cell 310 of the second embodiment, may include a homojunction crystalline silicon solar cell. Specifically, a semiconductor-type impurity doping layer different from the semiconductor-type crystalline silicon substrate 411 is used as the emitter layer 414, and an impurity doping layer having the same type of semiconductor as the crystalline silicon substrate 411 is used as the BSF layer 415 to provide the homojunction crystalline silicon solar cell 410. In this case, the passivation layers 412 and 413 made of amorphous intrinsic silicon are not required to be included.

Meanwhile, more specifically, according to the present disclosure, in the perovskite solar cell and the tandem solar cell including the same, the electron transport layer which is the n-type electron transport layer and having a composition containing silicon (Si) is made of one or two or more of amorphous silicon (n-a-Si), amorphous silicon oxide (n-a-SiO), amorphous silicon nitride (n-a-SiN), amorphous silicon carbide (n-a-SiC), amorphous silicon oxynitride (n-a-SiON), amorphous silicon carbonitride (n-a-SiCN), amorphous silicon germanium (n-a-SiGe), microcrystalline silicon (n-µc-Si), microcrystalline silicon oxide (n-µc-SiO), microcrystalline silicon carbide (n-µc-SiC), microcrystalline silicon nitride (n-µc-SiN) and microcrystalline silicon germanium (n-µc-SiGe).

According to the present disclosure, the electron transport layer may control the band gap and the work function of the n-type layer including the Si alloy or Si through the control of a composition and a doping concentration of the Si alloy.

Meanwhile, in Embodiment 4 of the present disclosure, as the amorphous silicon (a-Si), microcrystalline silicon (µC-Si), and polycrystalline silicon (poly-Si) chemically the same components, as described in Embodiment 2, these silicon are clearly distinguished from one another through physical methods such as Raman spectroscopic measurement. Therefore, the description thereof is replaced with the description in Embodiment 2.

Meanwhile, according to the present disclosure, the layer including doped silicon (Si) which is the electron transport layer preferably has electrical conductivity of 10⁻⁵ S/cm or more.

Based on the electrical conductivity thereof being less than the 10⁻⁵ S/cm, the charge mobility is basically too low to perform the basic function for a hole transport layer or an electron transport layer.

Further, the electron transport layer preferably has a thickness of 10 to 100 nm.

Based on the electron transport layer having the thickness less than 10 nm, there is a high possibility that tunneling occurs and the electron transport layer may not function for the electron transport layer itself. Meanwhile, based on the electron transport layer having the thickness greater than 100 nm, there may be a problem that the light transmittance is lowered due to excessive thickness thereof.

In Embodiment 4 of the present disclosure, the electron transport layer which is the n-type electron transport layer and having a composition containing silicon (Si) is coupled to the perovskite absorption layer including a formamidinium (FA) component, as described in Embodiment 2, to provide a synergistic effect in terms of band gap design.

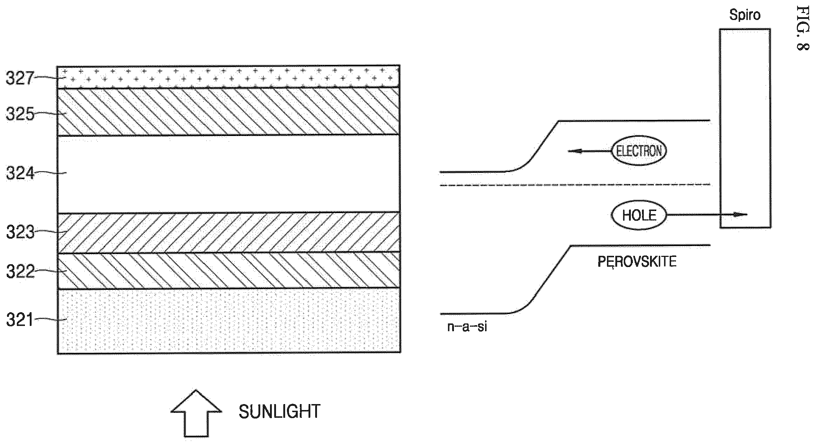

FIG. 8 shows a perovskite solar cell and a band gap corresponding thereto according to a first embodiment of the present disclosure. As described in Embodiment 2 above, it is known that an FA-based perovskite absorption layer has a band gap (about 1.45 eV) less than a band gap (about (1.55 to 1.6) eV) of the MA-based perovskite absorption layer in the present disclosure.

Therefore, according to the present disclosure, it can be seen from FIG. 8 that, in the case of the n-type electron transport layer including the Si thin film layer coupled to the FA-based ferovskite absorption layer, electrons generated by the perovskite absorption layer are more easily transported to the n-type electron transport layer including Si thin film layer due to a less band gap, compared to the n-type electron transport layer including the Si thin film layer coupled to the MA-based perovskite absorption layer.

Therefore, with respect to solar cells in Embodiments 3 and 4 of the present disclosure, the perovskite absorption layer is preferably made of material containing formamidinium (FA) component.

More preferably, FA₁₋ₓCsₓPbBr_{y}I_{3-y} (where 0 ≤ x ≤ 1 and 0 ≤ y ≤ 3) is preferable. The FA-based perovskite absorption layer has an advantage that FA-based perovskite absorption layer has excellent high temperature stability than that high temperature stability of the MA-based perovskite absorption layer, and may suppress the generation of unwanted delta (δ) phase FA-based compounds due to the addition of Cs.

Further, the band gap of the FA-based perovskite absorption layer may be increased to a degree similar to the band gap of other MA-based perovskite absorption layers due to the addition of Br. When the band gap energy is in the high range, the high-band gap perovskite layer absorbs light of short wavelength compared to other silicon solar cells, thereby reducing the thermal loss caused by the difference between the photon energy and the band gap to generate a high voltage. As a result, the efficiency of the solar cell is eventually improved.

The hole transport layer in the third and fourth embodiments of the present disclosure may be made of other materials of hole transport layers without change.

For example, the hole transport layer 425 may be made of a conductive polymer. That is, polyaniline, polypyrrole, polythiophene, poly-3,4-ethylenedioxythiophene-polystyrenesulfonate (PEDOT-PSS), poly-[bis(4-phenyl) (2,4,6)-trimethylphenyl)amine] (PTAA), Spiro-MeOTAD or polyaniline-camporsulfonic acid (PANI-CSA) may be used as the conductive polymer. In this case, the hole transport layer 123 may further include an n-type or p-type dopant as necessary.

In addition to the organic materials, inorganic materials such as NiO, MoS₂, MoOₓ, CuI, and CuSCN, which are two-dimensional materials, may be preferably used alone or by being additionally inserted into the conductive polymer as the material of the hole transport layer 425.

### Manufacturing Method in Embodiments 1 and 2

A method for manufacturing solar cells in Embodiments 1 and 2 according to the present disclosure is described below.

Manufacturing methods in Embodiments 1 and 2 of the present disclosure are substantially the same as manufacturing methods in Examples 3 and 4 of the present disclosure and stacking structures or stacking sequences in Embodiments 1 and 2 of the present disclosure are only different from stacking structures or stacking sequences in Examples 3 and 4 of the present disclosure. Therefore, the method for manufacturing the solar cell of the present disclosure is described below through the method for manufacturing solar cells in Embodiments 1 and 2.

First, a substrate on which a perovskite solar cell is laminated is prepared to manufacture a solar cell of the present disclosure. In this case, a substrate corresponds to a glass substrate in the first embodiment and a substrate corresponds to a crystalline silicon solar cell in the second embodiment.

First, in the case of a glass substrate for a perovskite solar cell, a glass substrate including a soda lime component and having desired sheet resistance is cleaned with an organic solvent such as ethanol and deionized (DI) water as necessary. At this time, iron (Fe) content in the glass substrate may be preferably less.

Meanwhile, a crystalline silicon solar cell is prepared first to manufacture a tandem solar cell.

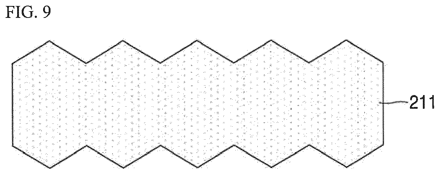

More specifically, as shown in FIG. 9, first, a first surface and a second surface of the crystalline silicon substrate 211 are planarized, and subsequently, at least one of the first surface and the second surface thereof is textured to form a texturing pattern.

In this case, any one of a wet chemical etching method, a dry chemical etching method, an electrochemical etching method, and a mechanical etching method may be used to introduce the texture structure of the crystalline silicon substrate 211. However, the present disclosure is not necessarily limited thereto. For example, a texture structure may be introduced by etching, in a basic aqueous solution, at least one of the first surface and second surface of the crystalline silicon substrate 111.

More specifically, first, an n-type silicon single crystal substrate having a thickness of several hundreds to thousands of micrometers sliced along a (100) plane is prepared. Subsequently, a substrate surface is etched using an aqueous solution including additives such as organic solvents, phosphates, reaction regulators and/or surfactants and an aqueous solution of sodium hydroxide (NaOH) or potassium hydroxide (KOH) having 1 to 5% by weight in a temperature range of room temperature to 150°C.

The organic solvent may be at least one of 2-methyl-2,4-pentanediol, propylene glycol, 2,2,4-trimethyl-1,3-pentanediol, 1,3-butanediol, 1,4-butanediol, 1,6-hexanediol, 2,2-dimethyl-1,3-propanediol, hydroquinone, 1,4-cyclohexanediol, and N-methyl proline.

Further, the phosphate may be at least one of K₃PO₄ and K₂HPO₄.

A texture having pyramidal concavo-convex is formed on the silicon single crystal substrate through etching. As the silicon single crystal has a diamond cubic structure, a {111} plane is a closest plane and is chemically stable. Therefore, an etching rate of the {111} plane for the aqueous sodium hydroxide solution is the slowest. As a result, after etching, anisotropic etching of the the silicon substrate occurs along the {111} plane. As a result, a texture having a depth of 0.1 to 10 µm is uniformly formed on entire surfaces of the silicon substrate.

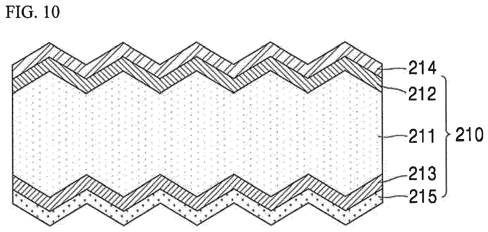

Subsequently, an emitter layer 214 is formed on a first surface of the crystalline silicon substrate 211. After the emitter layer 214 is formed, a BSF layer 215 may be further formed on a second surface of the crystalline silicon substrate 211 (see FIG. 10).

In the case of a heterojunction silicon solar cell, first, an amorphous intrinsic silicon (i-a-Si:H) layer is deposited, as the passivation layers 212 and 213, on both surfaces of the p-type silicon crystalline substrate 211 including the uniformly formed texture through plasma enhanced chemical vapor deposition (PECVD) using silicon source materials (SiH4, Si₂H₆, and the like) and hydrogen (H₂). As a process temperature may be lowered through the PECVD compared to general chemical vapor deposition (CVD), the PECVD is desirable as a method of manufacturing a heterojunction silicon solar cell.

Subsequently, an emitter layer 214 doped with semiconductor-type impurities, which is different from the silicon crystalline substrate and the BSF layer 215 doped with semiconductor-type impurities, which is identical to the silicon crystalline substrate are formed. Specifically, at least one selected from the group consisting of SiH4, Si₂H₆, SiHCl₃, and SiH₂Cl₂, H₂ gas, and B₂H₆ or PH3 gas as a dopant gas are used as a reactant through the PECVD process. At this time, the temperature and pressure conditions of the PECVD process may be the same as the PECVD conditions of the amorphous intrinsic silicon layer.

By contrast, in the case of a homojunction silicon solar cell, the emitter layer 214 and the BSF layer 215 may be formed through an ion implantation process without the passivation layer. The emitter layer 214 is doped with phosphorus as an impurity, and a BSF layer 215 is doped with boron as an impurity.

When the emitter layer 214 and the BSF layer 215 are formed through the ion implantation process, it is desirable to involve heat treatment at 700 to 1,200°C for activation of impurities. The emitter layer 214 and the BSF layer 215 may also be formed through a high-temperature diffusion process using BBr₃ or PCl₃ instead of the ion implantation process.

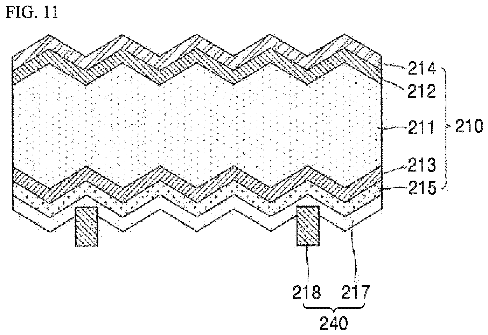

As shown in FIG. 11, a second electrode 240 including the transparent electrode layer 217 and the metal electrode layer 218 is formed on the second surface of the crystalline silicon substrate 211.

In the case of the heterojunction silicon solar cell as described above, a process temperature of the second electrode (the metal electrode layer 218) is limited to be equal to or less than 250°C, which is a process temperature of the first electrode 230 in order to prevent hydrogen bond from being destroyed inside the amorphous silicon. Therefore, in this case, the second electrode 240 may be formed before the first electrode 230 or the second electrode 240 and the first electrode 230 may be formed at the same time.

The second electrode 240 first forms the transparent electrode layer 217 on the BSF layer 215. The transparent electrode layer 217 may be deposited through sputtering when the transparent conductive oxide such as indium tin oxide (ITO), zinc indium tin oxide (ZITO), zinc indium oxide (ZIO), and zinc tin oxide (ZTO) is used as the material of the transparent electrode layer.

After the transparent electrode layer 217 is formed, a grid electrode 218 which is a metal electrode layer is formed. Of course, the grid electrode 218 may be formed right above the BSF layer 215 without forming the transparent electrode layer 217. However, amorphous silicon has relatively low carrier mobility to collect carriers through a metal grid. Thus, it is more desirable to form the transparent electrode layer 217.

In this case, the grid electrode 218, which is a metal electrode layer, is formed by printing a second electrode paste above the transparent electrode layer 217 through screen printing, and by heat treatment with a second temperature (identical to a first temperature).

The second electrode (the metal electrode layer 218) may be manufactured by selectively applying a second electrode paste containing no glass frit, and subsequently, low-temperature firing at the second temperature. The second electrode paste may contain an organic material which is a low-temperature firing binder and a metal particle, and the second electrode paste may not include glass frit. In particular, the second temperature may be 250°C or less, more specifically 100°C to 200°C.

By contrast, in the case of a homojunction silicon solar cell, the second electrode 240 and the first electrode 230 may not be formed at the same time, but the second electrode 240 and the first electrode 230 may be formed through two processes, e.g., a process of forming the second electrode 240 through the high-temperature firing at 700°C or more and a process of forming the first electrode 230 with low-temperature firing at 250°C or less using the first electrode paste containing no glass frit.

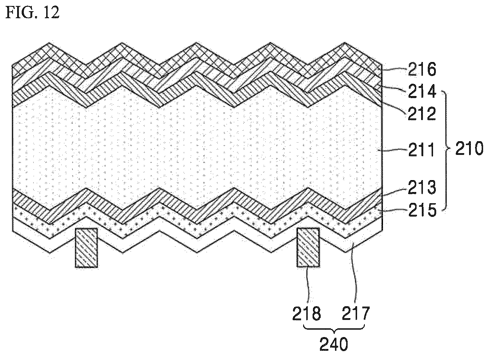

A transparent conductive material is deposited on the transparent electrode 122 on the glass substrate or the inter-layer 216 above the crystalline silicon solar cell (see FIG. 12). In the present disclosure, a transparent electrode or an inter-layer 216 is formed on the substrate using a generally known sputtering method, more specifically, RF magnetron sputtering. Fluorine tin oxide (FTO) was deposited to form the transparent electrode 122, and aluminum doped zinc oxide (AZO) was used for the inter-layer 216, but the material is not limited thereto. Various transparent conductive oxide, metallic materials, conductive polymers, and the like may also be used.

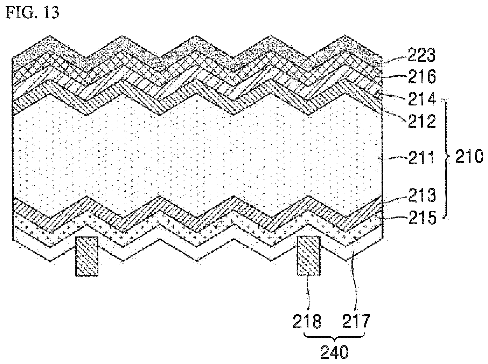

According to the present disclosure, the perovskite solar cell and the tandem solar cell including the same form a hole transport layer 213 on a layer made of the transparent conductive material (see FIG. 13).

According to the present disclosure, the hole transport layer, similar to the emitter layer 214, is manufactured using, as a reactant, at least one selected from the group consisting of SiH4, Si₂H₆, SiHCl₃ and SiH₂Cl₂, H₂ gas, and B₂H₆ gas as a dopant gas through the PECVD process. At this time, the temperature and pressure conditions of the PECVD process may be the same as the PECVD conditions of the amorphous intrinsic silicon layer. Therefore, p-type amorphous silicon (p-a-Si) is deposited on the hole conductive layers in the first embodiment and the second embodiment of the present disclosure under such process conditions.

Meanwhile, according to the present disclosure, the hole transport layer may be made of microcrystalline silicon (p-µC-Si) or polycrystalline silicon (p-poly-Si) as well as the amorphous silicon. The microcrystalline or polycrystalline silicon layer may be obtained by performing the crystallization of the amorphous silicon layer through heat treatment.

The layer made of silicon compounds, for example, silicon carbide, in addition to the pure silicon layer, may also be deposited through a relatively low-temperature process (equal to or less than 250°C) of the PECVD. Specifically, hexamethyldisilane (HMDS), (CH₃)₆Si₂) is used as a deposition material and H₂ is used as the carrier gas. C₂H₂ gas is also used to supply carbon into a silicon carbide film and to fix an amount of carbon. Flow rates of argon, hydrogen and C₂H₂ gas is controlled using a mass flow controller (MFC), and a flow rate of HMDS raw material is adjusted by changing flow of carrier gas and line pressure. At this time, the deposition temperature thereof may be lowered to a minimum of 200 to 250°C.

Meanwhile, in the present disclosure, a buffer layer 223' (see FIG. 3) may be further formed above the hole transport layer as necessary.

In this case, it may be deposited through a relatively low-temperature process, such as PECVD, when NOₓ, which is metal oxide, is used for the buffer layer. There is an advantage that copper thiocyanate (CuSCN) may be manufactured through the solution process at low temperatures when the buffer layer is made of copper thiocyanate (CuSCN).

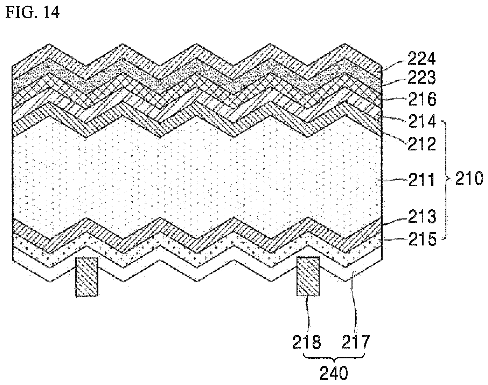

The perovskite absorption layer 224 made of FA₁₋ₓCsₓPbBr_{y}I_{3-y} component is formed again on the hole transport layer (see FIG. 14). According to the present disclosure, the perovskite absorption layer may also be formed through a thin film process as well as the solution process in related art.

The solution processes in related art refers to processes such as inkjet printing, gravure printing, spray coating, doctor blades, bar coating, gravure coating, brush painting, and slot-die coating for the perovskite absorption layer.

The solution process has an advantage in that a light absorber of a photo-activation layer may be formed through a very simple, easy, and inexpensive process, for example, application and drying of a solution. Crystallization is also spontaneously performed by drying of the applied solution to form the light absorber having coarse grains, and in particular, there is an advantage in that excellent conductivity of both electrons and holes is provided.

Meanwhile, as can be seen from the solution process itself, when the substrate has a texture having a concave-convex structure as described in Embodiment 2 of the present disclosure, the film tends to be planarized due to leveling properties after the application of the solution. In this case, the path of the light passing through the first electrode 230 may be shortened and the reflectance may increase, resulting in a problem that the efficiency of the solar cell is degraded.

According to the present disclosure, in addition to the solution process, the perovskite absorption layer 224 is formed through physical vapor deposition or chemical vapor deposition using sputtering or electron beam. In this case, the perovskite absorption layer may be formed by either single step deposition or sequential step deposition; however, the sequential step is more preferable than the single step due to difficulties in manufacturing of a uniform thin film.

After the perovskite absorption layer 224 as described above is formed, a post-heat treatment process is performed in the preset disclosure to change a material of the perovskite absorption layer 224 to a perovskite material. The post-heat treatment process is carried out within about 3 hours in a temperature range from room temperatures to 200°C. A lower limit of the post-heat treatment temperature is not particularly limited, and based on the temperature being greater than 200°C, the polymer material of the perovskite absorption layer may be thermally degraded. During the deposition process, precursor layers may also be pyrolyzed or composition changes may be caused by pyrolysis based on the reaction between the precursor layers before the perovskite layer is formed.

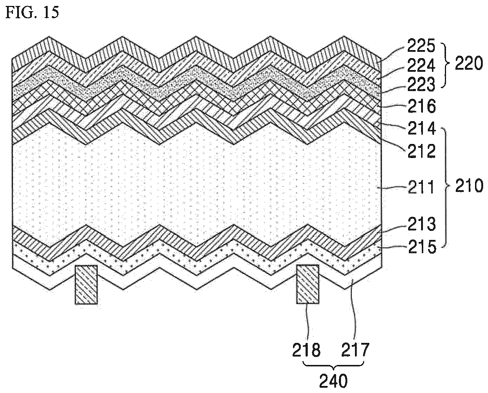

When the perovskite absorption layer 224 is formed, an electron transport layer 225 is formed thereon (see FIG. 15). The electron transport layer 225 is a layer for easily transferring electrons generated by the perovskite layer to the first electrode 230, and may be able to provide the transmission of visible light and the conductivity of electrons.

In the present disclosure, the electron transport layer is made of a mixture of one or two or more of of ZnO, SnO₂, CdS, PCBM, or C₆₀.

In the case of C₆₀, fullerene derivative containing C₆₀ is dissolved in a solvent, and is spin-coated for 10 to 30 seconds through a spin coating method, and subsequently is maintained at room temperature for 1 to 3 hours to form an electron transport layer.

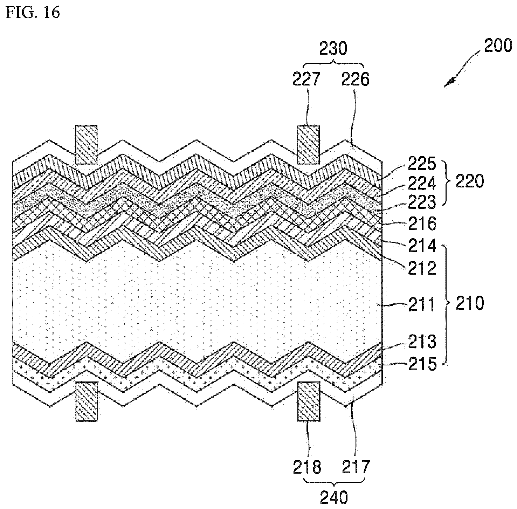

The front transparent electrode 226 is formed on the electron transport layer as necessary, and subsequently, a final first electrode (a metal electrode layer 227) is formed thereon (see FIG. 16).

At this time, the transparent electrode layer 226 is formed on the entire upper surface of the perovskite solar cell 220, and functions to collect the charge generated by the perovskite solar cell 220. The transparent electrode layer 226 may be made of various types of transparent conductive materials. That is, the same transparent conductive material as the inter-layer 216 may be used.

In this case, the first electrode (the metal electrode layer 227) is disposed on the transparent electrode layer 226 and is disposed at an area of a portion of the transparent electrode layer 226.

The first electrode 230 may be manufactured by selectively applying a first electrode paste containing no glass frit, and low-temperature firing at a first temperature. The first electrode paste may include metal particles and an organic material which is a binder for low-temperature firing, and the first electrode paste may not include the glass frit. In particular, the first temperature may be 250°C or less, more specifically, 100°C to 200°C.

As described above, in the case of the heterojunction silicon solar cell, the second electrode 240 and the first electrode 230 may be simultaneously formed when the first electrode 230 is formed, or after the second electrode 240 is formed, the perovskite solar cell is formed, and subsequently, the first electrode 230 may be formed. Further, in the case of the heterojunction silicon solar cell, both the first electrode 230 and second electrode 240 are formed through the low-temperature firing process performed at 250°C or less.

As described above, while the present disclosure has been described with reference to exemplary drawings thereof, the present disclosure is not limited to embodiments and drawings described in the present disclosure, and various changes can be made by the skilled person in the art in the scope of the technical idea of the present disclosure. Further, in the description of embodiments of the present disclosure, working effects obtained based on configurations of the present disclosure are not explicitly described, it is needless to say that effects predicted based on the corresponding configurations have also to be recognized.

## Claims

1. A solar cell comprising:
a hole transport layer which is a p-type hole transport layer and having a composition containing silicon (Si);
a perovskite layer disposed on the hole transport layer; and
an electron transport layer disposed on the perovskite layer.

2. The solar cell of claim 1, **characterized in that** the hole transport layer is disposed on a transparent electrode disposed on a transparent substrate and a metal electrode layer is disposed above the electron transport layer.

3. The solar cell of claim 1, **characterized in that**
the solar cell further comprises a silicon solar cell comprising a crystalline silicon substrate and the hole transport layer is disposed above the silicon solar cell;
the solar cell comprising a front electrode disposed above the electron transport layer.

4. The solar cell of claim 3, **characterized in** comprising an inter-layer between the silicon solar cell and the hole transport layer.

5. The solar cell of claim 2 or 3, **characterized in** comprising a buffer layer between the hole transport layer and the perovskite layer.

6. The solar cell of claim 5, **characterized in that** the buffer layer is made of one or two or more of NiOₓ, MoOₓ, CuSCN, and CuI.

7. The solar cell of claim 2 or 3, **characterized in** comprising a transparent electrode between the electron transport layer and an electrode.

8. The solar cell of claim 3, **characterized in that** the silicon solar cell comprises:
a first intrinsic amorphous silicon layer (i-a-Si:H) disposed on a first surface of the crystalline silicon substrate and a second intrinsic amorphous silicon layer (i-a-Si:H) disposed on a second surface of the crystalline silicon substrate;
a first semiconductor-type amorphous silicon layer disposed on the first intrinsic amorphous silicon layer; and
a second semiconductor-type amorphous silicon layer disposed on a rear surface of the second intrinsic amorphous silicon layer.

9. The solar cell of claim 1, **characterized in that** the p-type silicon (Si) layer is made of one or two or more of amorphous silicon (p-a-Si), amorphous silicon oxide (p-a-SiO), amorphous silicon nitride (p-a-SiN), amorphous silicon carbide (-pa-SiC), amorphous silicon acid nitride (p-a-SiON), amorphous silicon carbonitride (p-a-SiCN), amorphous silicon germanium (p-a-SiGe), microcrystalline silicon (p-µc-Si), microcrystalline silicon oxide (p-µc-SiO), microcrystalline silicon carbide (p-µc-SiC), microcrystalline silicon nitride (p-µc-SiN), and microcrystalline silicon germanium (p-µc-SiGe).

10. The solar cell of claim 1, **characterized in that** the perovskite layer comprises a material having a chemical formula of FA₁₋ₓCsₓPbBr_{y}I_{3-y} (where 0 ≤ x ≤ 1 and 0 ≤ y ≤ 3).

11. The solar cell of claim 1, **characterized in that** the electron transport layer is made of one or two or more of ZnO, SnO₂, CdS, PCBM, or C₆₀.

12. The solar cell, **characterized in** comprising an electron transport layer which is an n-type electron transport layer and comprising a composition containing silicon (Si); a perovskite layer disposed on the electron transport layer; and a hole transport layer on the perovskite layer.

13. -The solar cell of claim 12, **characterized in that**
the electron transport layer is disposed on a transparent electrode disposed on a transparent substrate and
a metal electrode layer is disposed above the hole transport layer.

14. The solar cell of claim 12, **characterized in that**
the solar cell further comprises a silicon solar cell comprising a crystalline silicon substrate and the electron transport layer is disposed above the silicon solar cell;
the solar cell comprising a front electrode disposed on the hole transport layer.

15. The solar cell of claim 14, **characterized in** comprising an inter-layer between the silicon solar cell and the electron transport layer.

16. The solar cell of claim 13 or 14, **characterized in** comprising a buffer layer between the electron transport layer and the perovskite layer.

17. The solar cell of claim 16, **characterized in that** the buffer layer is made of at least of TiOₓ, ZnO, SnO₂, CdS, PCBM, and C₆₀.

18. The solar cell of claim 13 or 14, **characterized in** comprising a transparent electrode between the hole transport layer and an electrode.

19. The solar cell of claim 14, **characterized in that** the silicon solar cell comprises a first intrinsic amorphous silicon layer (i-a-Si:H) disposed on a first surface of the crystalline silicon substrate and a second intrinsic amorphous silicon layer (i-a-Si:H) disposed on a second surface of the crystalline silicon substrate; a first semiconductor-type amorphous silicon layer disposed on the first intrinsic amorphous silicon layer; and a second semiconductor-type amorphous silicon layer disposed on a rear surface of the second intrinsic amorphous silicon layer.

20. The solar cell of claim 12, **characterized in that** the layer which is the n-type layer and having a composition containing silicon (Si) is made of one or two or more of amorphous silicon (n-a-Si), amorphous silicon oxide (n-a-SiO), amorphous silicon nitride (n-a-SiN), amorphous silicon carbide (n-a-SiC), and amorphous silicon oxynitride (n-a-SiON), amorphous silicon carbonitride (n-a-SiCN), amorphous silicon germanium (n-a-SiGe), microcrystalline silicon (η-µc-Si), microcrystalline silicon oxide (n-µc-SiO), microcrystalline silicon carbide (η-µc-SiC), microcrystalline silicon nitride (n-µc-SiN), microcrystalline silicon germanium (n-µc-SiGe).

21. The solar cell of claim 12, **characterized in that** the perovskite layer comprises a material having a chemical formula of FA₁₋ₓCsₓPbBr_{y}I_{3-y} (where 0 ≤ x ≤ 1 and 0 ≤ y ≤ 3).

22. The solar cell of claim 12, **characterized in that** the hole transport layer is made of one or two or more of PEDOT-PSS, Spiro-OMeTAD, PTAA, NiO, MoS₂, MoOₓ, CuI, and CuSCN.
